# EUROPEAN PATENT APPLICATION

(11) **EP 4 722 745 A1**
(43) Date of publication of application: **08.04.2026**
(21) Application number: 24815250.6
(22) Date of filing: 17.05.2024
(51) Int. Cl.: G01R 31/28, G01R 31/26, H01L 21/66, H01L 27/144

(54) **INSPECTION DEVICE AND INSPECTION METHOD**

(30) Priority: 31.05.2023 JP 2023090424
(71) Applicant: Tokyo Electron Limited, Tokyo 107-6325 (JP)
(72) Inventor: KOBAYASHI, Masahito, Nirasaki City, Yamanashi 4078511 (JP); TAKASE, Fumiya, Nirasaki City, Yamanashi 4078511 (JP)
(74) Representative: Hoffmann Eitle
(86) International application number: PCT/JP2024/018348
(87) International publication number: WO 2024/247766

(57) **Abstract**

This inspection device inspects an inspection object which has an imaging device into which light enters from a side opposite a wiring layer. The inspection device includes: a mounting platform through which light can pass that has a mounting surface on which the inspection object is to be mounted in a manner facing the opposite side of the imaging device with respect to the wiring layer; a mounting platform operating part capable of moving the mounting platform vertically and horizontally; and an irradiation device that irradiates inspection light onto the imaging device through the mounting surface. The mounting platform operating part changes, by moving the mounting platform, the relative position of the irradiation device with respect to the inspection object mounted on the mounting surface.

## Description

### Technical Field

The present disclosure relates to an inspection apparatus and an inspection method.

### Background

A substrate (inspection object) having an imaging device such as a CMOS image sensor is inspected by irradiating inspection light to the substrate from a light emitting part including a plurality of LEDs and determining whether each pixel of the imaging device is defective or non-defective. Recently, in order to improve an S/N ratio and reduce power consumption, a backside irradiation type imaging device in which light is incident from a surface opposite to a wiring layer has been developed, and an inspection apparatus that performs inspection suitable for such an imaging device is also being developed. For example, Patent Document 1 discloses an inspection apparatus in which a substrate having a plurality of imaging devices is placed on a placing table and a light emitting part (irradiation device) that irradiates inspection light from the same placing table side is provided.

### Prior Art Documents

### Patent Documents

Patent Document 1: Japanese Laid-Open Patent Publication No. 2020-68329

### Summary

### Problems to Be Resolved by the Invention

The present disclosure provides a technique for accurately inspecting an imaging device.

### Means for Solving the Problems

According to one embodiment of the present disclosure, an inspection apparatus for an inspection object having an imaging device to which light is incident from a surface opposite to a wiring layer comprises a light-transmitting placing table having a placing surface on which the inspection object is placed so that the surface opposite the wiring layer of the imaging device faces the placing surface, a placing table operating part configured to move the placing table vertically and horizontally, and an irradiation device configured to irradiate inspection light to the imaging device through the placing surface, wherein the placing table operating part changes a relative position of the irradiation device with respect to the inspection object placed on the placing surface by moving the placing table.

### Effect of the Invention

In accordance with one aspect, the imaging device can be inspected accurately.

### Brief Description of the Drawings

FIG. 1 is a schematic cross-sectional view showing a configuration of an inspection apparatus according to an embodiment.
FIG. 2A is an enlarged cross-sectional view showing a part of an imaging device that is an inspection target device to be inspected by an inspection apparatus according to an embodiment.
FIG. 2B is an enlarged cross-sectional view showing a part of an imaging device according to a comparative example.
FIG. 3 is an enlarged cross-sectional view illustrating an inspection state of an imaging device.
FIG. 4 is a partial side cross-sectional view showing an overall configuration of an inspection part.
FIG. 5A is a plan view schematically showing a stage according to an embodiment.
FIG. 5B is a plan view schematically showing a stage according to a first modification.
FIG. 5C is a plan view schematically showing a stage according to a second modification.
FIG. 6 is a perspective view showing a horizontal movement mechanism for a stage.
FIG. 7A is a plan view schematically showing a placing table of a stage.
FIG. 7B is a side view schematically showing the placing table.
FIG. 7C is a side cross-sectional view schematically showing a laminated structure taken along line VIIB-VIIB of FIG. 7B.
FIG. 7D is a side cross-sectional view schematically showing a laminated structure according to a modification.
FIG. 8 is a flowchart illustrating an inspection method of an inspection apparatus.
FIG. 9 is a partial side cross-sectional view showing an overall configuration of an inspection part according to another embodiment.

### Detailed Description

Hereinafter, embodiments of the present disclosure will be described with reference to the accompanying drawings. Like reference numerals will be used for like parts throughout the drawings, and redundant description thereof may be omitted.

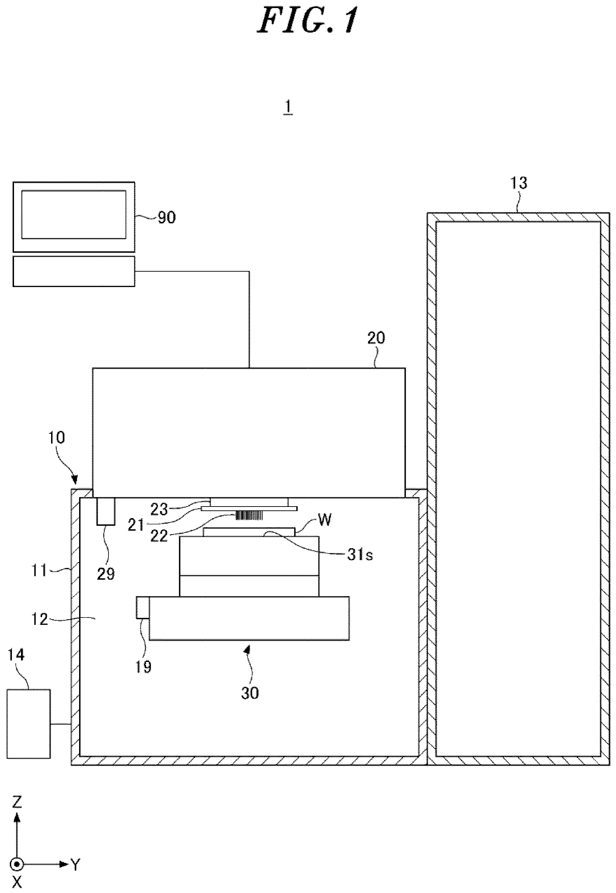

FIG. 1 is a schematic cross-sectional view showing a configuration of an inspection apparatus 1 according to an embodiment. As shown in FIG. 1, the inspection apparatus 1 inspects a substrate that is an inspection object having an inspection target device. The substrate to be inspected is formed in a perfect circular shape in plan view, for example, and has a plurality of inspection target devices arranged in a matrix pattern (hereinafter, the substrate may also be referred to as "wafer W"). The inspection object is not limited to a wafer W having a plurality of inspection target devices, and may also be a carrier having an inspection target device, a single chip, an electronic circuit board, or the like.

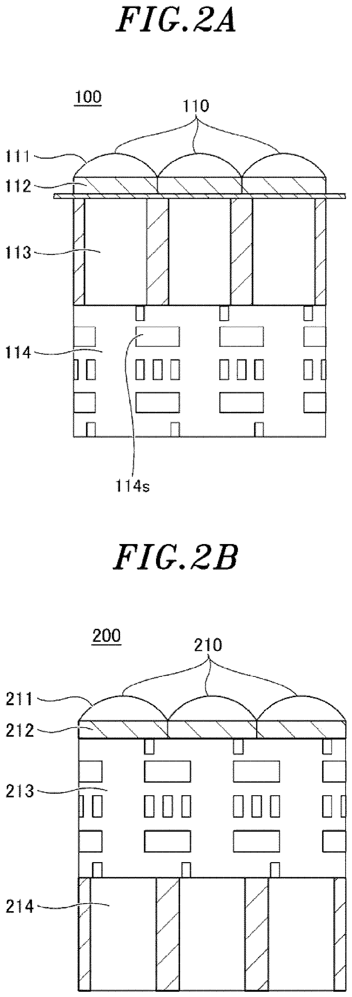

FIG. 2A is an enlarged cross-sectional view showing a part of an imaging device 100 that is an inspection target device to be inspected by the inspection apparatus 1 according to an embodiment. FIG. 2B is an enlarged cross-sectional view showing a part of an imaging device 200 according to a comparative example. As shown in FIG. 2A, an inspection target device to be inspected by the inspection apparatus 1 may be an imaging device 100 that is a solid-state imaging device using a complementary metal oxide semiconductor (CMOS). The CMOS imaging device 100 includes one photodiode 113 and a CMOS transistor switch 114s for each of pixels 110 arranged in a grid pattern. The switch 114s is switched for each pixel 110 to amplify a signal and directly read it out.

However, the performance of the imaging device 100 varies depending on the arrangement of the laminated structure that constitutes the pixel 110. Hereinafter, in order to facilitate understanding of the imaging device 100 of the embodiment, a comparative (conventional) imaging device 200 will be described first with reference to FIG. 2B.

A plurality of pixels 210 of the imaging device 200 according to the comparative example detect a color (e.g., one of RGB colors) that is registered in a color filter 212 laminated on an upper side of a photodiode 214. Each pixel 210 has a laminated structure in which an on-chip lens 211, a color filter 212, a wiring layer 213, and a photodiode 214 are sequentially laminated in that order.

In other words, in the imaging device 200, the wiring layer 213 is located between the color filter 212 and the photodiode 214. The inspection light incident from the on-chip lens 211 passes through the color filter 212 and the wiring layer 213, and then is incident on the photodiode 214. In this case, pads (not shown) connected to the wiring layer 213 can be positioned on the on-chip lens 211 side, so that the inspection apparatus can perform inspection by arranging probes and the inspection light to be irradiated to the imaging device 200 in the same direction. Hereinafter, the imaging device 200 having the laminated structure shown in FIG. 2B is referred to as a "front side irradiation type imaging device."

Since, however, the inspection light passes through the wiring layer 213, the photodiode 214 of the imaging device 200 receives the inspection light with a significant loss. Further, in the front side irradiation type imaging device 200, the pads are located on the on-chip lens 211 side, so that the dead space on the wafer W becomes larger.

As shown in FIG. 2A, the plurality of pixels 110 of the imaging device 100 have a laminated structure in which on-chip lenses 111, color filters 112, photodiodes 113, and a wiring layer 114 are sequentially laminated in that order. In other words, in the imaging device 100, the photodiodes 113 are located on the back surfaces of the color filters 212, and the light incident from the on-chip lenses 111 passes through the color filter 112 and then is incident on the photodiodes 113.

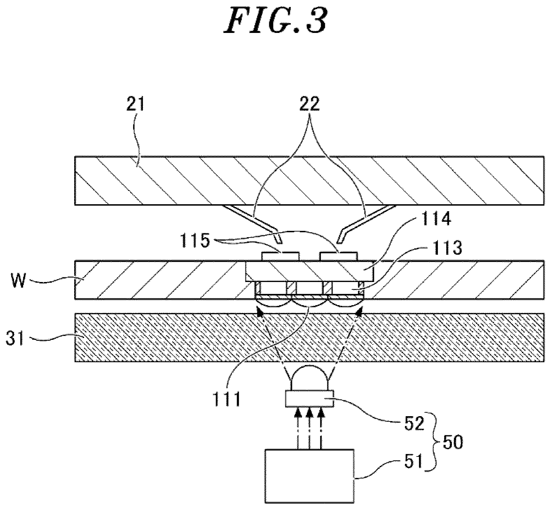

In this case, pads 115 (see FIG. 3: electrode pads or semiconductor bumps) connected to the wiring layer 114 can be located on the side opposite to the side where the on-chip lenses 111 are located. The inspection apparatus 1 performs inspection by locating an inspection light irradiation device 50 (see FIG. 3) that irradiates light to the imaging device 100 on the side opposite to the side where the probes 22 to be in contact with the pad 115 are provided. Hereinafter, the imaging device 100 having the laminated structure shown in FIG. 2A is referred to as a "backside irradiation type imaging device."

In the backside irradiation type imaging device 100, the inspection light can enter the photodiodes 113 without being affected by the wiring layer 114, which results in considerable improvement of the detection sensitivity. Further, the backside irradiation type imaging device 100 can reduce the dead space on the wafer W.

Hereinafter, the inspection principle of the backside irradiation type imaging device 100 will be described with reference to FIG. 3. FIG. 3 is an enlarged cross-sectional view illustrating an example of an inspection state of the imaging device 100.

In the inspection apparatus 1, in the case of inspecting the imaging device 100, the wafer W is placed with the on-chip lens 111 side facing the placing table 31, and the probes 22 of the inspection apparatus 1 are brought into contact with the pads 115 of the wiring layer 114 of each imaging device 100. Further, in the inspection apparatus 1, the inspection light of which color, light amount (radiation intensity), and angle are controlled is irradiated from the irradiation device 50 located on the stage 30 side to the wafer W. In the inspection apparatus 1, a tester 20 receives an electrical signal of each imaging device 100 during the irradiation to determine whether each imaging device 100 is defective or non-defective. Hereinafter, the configuration of the inspection apparatus 1 will be described in detail.

Referring back to FIG. 1, the inspection apparatus 1 includes an inspection part 10 that actually performs the inspection, a loader 13 installed adjacent to the inspection part 10, and a tester 20 installed above the inspection part 10. The inspection apparatus 1 further includes a controller 90 that controls the operations of the inspection part 10, the loader 13, and the tester 20.

The inspection part 10 includes a rectangular parallelepiped housing 11 where an inspection chamber 12 is provided. A stage 30 that places a wafer W thereon and transfers the wafer W to a desired three-dimensional position is accommodated in the inspection chamber 12.

A front-opening unified pod (FOUP) (not shown) holding a plurality of wafers W is set in the loader 13. The loader 13 includes a transfer device (not shown). The wafer W is taken out from the FOUP and transferred to the stage 30 in the inspection chamber 12 by the transfer device. Further, the transfer device in the loader 13 transfers an inspected wafer W from the stage 30 into the FOUP.

In the inspection part 10, a probe card 21 connected to the tester 20 via an interface 23 is provided above the inspection chamber 12. The probe card 21 has a plurality of probes 22 at positions facing the wafer W. When the wafer W is moved by the stage 30, the probes 22 are brought into contact with the electrode pads or the solder bumps of the inspection target devices of the wafer W. Accordingly, the tester 20 outputs a power and various signals to the devices to be inspected via the probe card 21 and the interface 23, and receives signals transmitted from the inspection target devices via the probe card 21 and the interface 23.

The tester 20 has therein a motherboard (not shown) connected to the interface 23. The motherboard has a plurality of slots to which a plurality of test boards (not shown) are attached, and is connected to the controller 90. The motherboard determines whether the inspection target devices of the wafer W are defective or non-defective based on the signals transmitted from the inspection target devices. By appropriately replacing the test boards, the tester 20 can perform multiple types of inspection.

Further, the inspection apparatus 1 may include an inspection-side camera 29 at an appropriate position in the inspection chamber 12 to capture images of the wafer W on the stage 30. The inspection-side camera 29 captures the inclination of the stage 30 or the position of the wafer W placed on the stage 30, for example. The inspection apparatus 1 may also include a stage-side camera 19 that captures images of the contact state between the probe card 21 or the probes 22 and the wafer W.

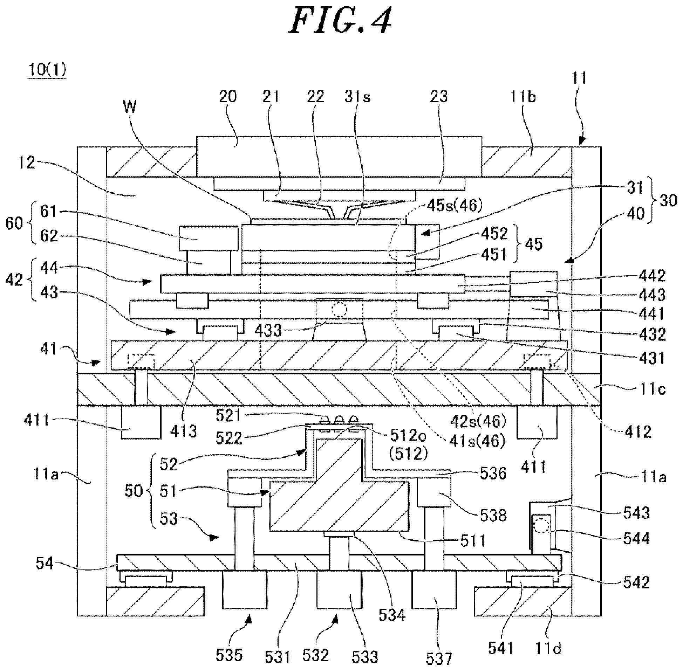

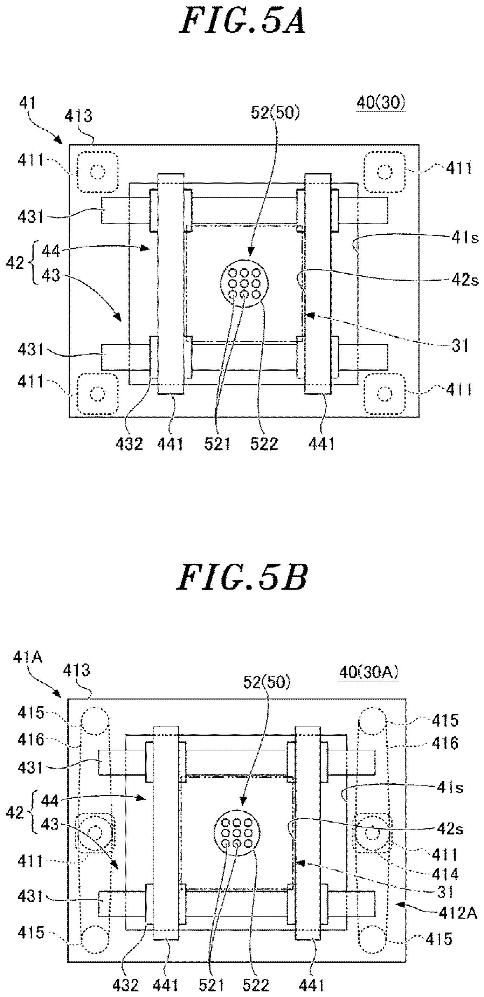

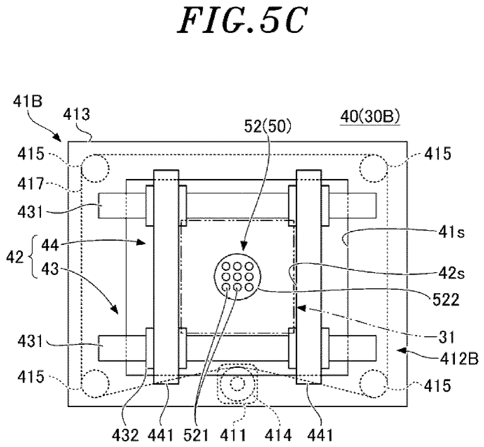

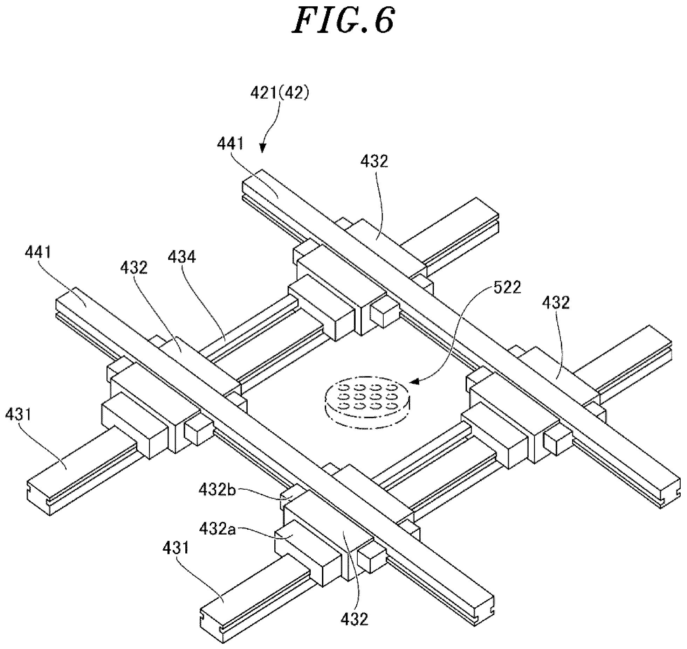

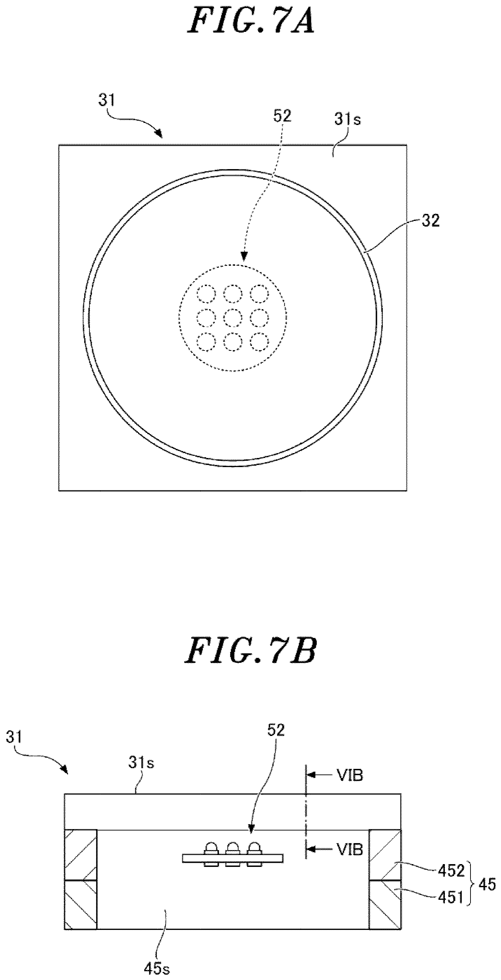

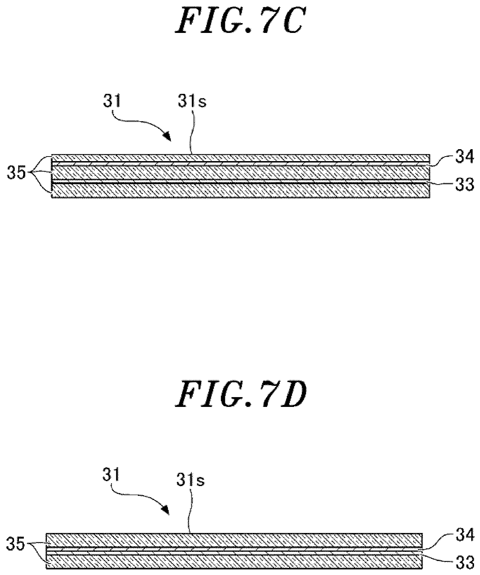

Hereinafter, the specific configuration of the inspection part 10 will be described in detail with reference to FIGS. 4 to 7. FIG. 4 is a partial side cross-sectional view showing the overall configuration of the inspection part 10. FIG. 5A is a plan view schematically showing the stage 30 according to an embodiment. FIG. 5B is a plan view schematically illustrating a stage 30A according to a first modification. FIG. 5C is a plan view schematically illustrating a stage 30B according to a second modification. FIG. 6 is a perspective view showing a horizontal movement mechanism 42 of the stage 30. FIG. 7A is a plan view schematically illustrating the placing table 31 of the stage 30. FIG. 7B is a side view schematically illustrating the placing table 31. FIG. 7C is a side cross-sectional view schematically illustrating the laminated structure taken along line VIIB-VIIB of FIG. 7B. FIG. 7D is a side cross-sectional view schematically illustrating the laminated structure according to a modification.

As shown in FIG. 4, the housing 11 of the inspection part 10 has a plurality of support columns 11a extending vertically inside a panel (not shown), and also has a plurality of horizontal frames connected to the support columns 11a and extending horizontally. The plurality of horizontal frames include, e.g., a ceiling frame 11b that supports the tester 20, an intermediate frame 11c that supports the stage 30, and a floor frame 11d that supports the irradiation device 50. The inspection chamber 12 of the inspection part 10 is divided into an upper space and a lower space by the intermediate frame 11c. The intermediate frame 11c is formed as a rectangular ring-shaped frame body that encircles the housing 11, and the upper space and the lower space communicate with each other.

The stage 30 moves the wafer W in the inspection chamber 12 to bring the imaging device 100 into contact with the probes 22 of the probe card 21. Specifically, the stage 30 includes a placing table 31 on which the wafer W is placed, a placing table operating part 40 installed at the intermediate frame 11c to move the placing table 31, and a polishing mechanism 60 installed adjacent to the placing table 31 for polishing the probes 22.

Under instructions from the controller 90 (see FIG. 1), the placing table operating part 40 moves the wafer W placed on the placing table 31 to a target three-dimensional position in the inspection chamber 12. The placing table operating part 40 includes a Z-axis movement mechanism 41, a horizontal movement mechanism 42, and a θ-axis rotation mechanism 45 that are arranged in the vertical direction from bottom to top.

The Z-axis movement mechanism 41 raises and lowers the placing table 31 in the vertical direction (Z-axis direction). The Z-axis movement mechanism 41 includes a plurality of (four in this embodiment; see FIG. 5A) driving sources 411 installed at the intermediate frame 11c, a drive transmission part 412 that transmits the driving force of the driving sources 411, and a Z-axis movable table 413 supported by the drive transmission part 412.

As shown in FIG. 5A, the driving sources 411 are provided near the four corners of the intermediate frame 11c in a plan view. Each driving source 411 may be a motor, a cylinder mechanism, or the like. In the present embodiment, a motor is adopted. For example, each driving source 411 is fixed to the bottom surface of the intermediate frame 11c, and the driving shaft thereof protrudes upward in the vertical direction (see FIG. 4). Each driving source 411 is connected to the controller 90 (or a movement controller that controls movement under the command of the controller 90) via a driver (not shown), and the rotation timing and the rotation amount are adjusted by the controller 90.

The drive transmission part 412 may employ an appropriate mechanism depending on types of the driving source 411. For example, when the driving source 411 is a motor, a ball screw mechanism that converts the rotational motion of the motor into the linear motion may be used.

The Z-axis movable table 413 is located above the intermediate frame 11c in the vertical direction, and is raised or lowered in the Z-axis direction (vertical direction) in response to the driving of the driving sources 411. In plan view, the Z-axis movable table 413 has a quadrilateral ring shape with a space 41s at the center thereof, and supports the horizontal movement mechanism 42. The space 41s has a square shape in plan view, and is set to be larger than the irradiation device 50.

Further, the configuration of the Z-axis movement mechanism 41 is not limited thereto, and various other configurations may be employed. For example, the number of driving sources 411 of the Z-axis movement mechanism 41 is not limited to four. As shown in the first modification shown in FIG. 5B, a Z-axis movement mechanism 41A may include two driving sources 411. In this case, the Z-axis movement mechanism 41A may include driving pulleys 414 provided at the driving shafts of the driving sources 411, driven pulleys 415 provided at the corners of the Z-axis movable table 413, and may employ a drive transmission part 412A that links one driving pulley 414 and two driven pulleys 415 with a pair of endless belts 416.

For example, as in the second modification shown in FIG. 5C, the Z-axis movement mechanism 41B may include one driving source 411. In this case, the Z-axis movement mechanism 41B may include a driving pulley 414 provided at the driving shaft of one driving source 411, driven pulleys 415 provided at the corners of the Z-axis movable table 413, and may employ a drive transmission part 412B that links the driving pulley 414 and the driven pulleys 415 with a single endless belt 417.

The horizontal movement mechanism 42 moves the placing table 31 in horizontal directions (in the X-axis and Y-axis directions). As shown in FIGS. 4 and 6, the horizontal movement mechanism 42 according to the embodiment includes a frame structure 421 in which the Y-axis movement mechanism 43 and the X-axis movement mechanism 44 are integrated into a single unit.

Specifically, the frame structure 421 has a cross shape (lattice shape) in which a pair of (two) Y-axis rails 431 are arranged in parallel and a pair of (two) X-axis rails 441 are arranged to overlap the pair of Y-axis rails 431 in the vertical direction and intersect with each other. Although the horizontal movement mechanism 42 according to the embodiment has the configuration in which the X-axis movement mechanisms 44 are located above the Y-axis movement mechanisms 43, they may be arranged in a reverse manner.

The pair of Y-axis rails 431 of the Y-axis movement mechanism 43 are fixed to the upper surface of the Z-axis movable table 413, and extend along the Y-axis direction. The Y-axis movement mechanism 43 has a plurality of (four) Y-axis movable bodies 432 arranged on the pair of Y-axis rails 431. Each Y-axis movable body 432 is mounted to be movable along the Y-axis rails 431.

Two of the four Y-axis movable bodies 432 are provided for each Y-axis rail 431. One of the two Y-axis movable bodies 432 mounted on one Y-axis rail 431 is aligned in the X-axis direction with one of the two Y-axis movable bodies 432 mounted on the other Y-axis rail 431 adjacent thereto in parallel, and holds the same X-axis rail 441 between the pair of X-axis rails 441. Similarly, the other of the two Y-axis movable bodies 432 mounted on one Y-axis rail 431 is aligned in the X-axis direction with the other Y-axis movable body 432 mounted on the other Y-axis rail 431 adjacent thereto in parallel, and holds the same other X-axis rail 441 between the pair of X-axis rails 441.

The two Y-axis movable bodies 432 mounted on one Y-axis rail 431 and the two Y-axis movable bodies 432 mounted on the other Y-axis rail 431 are connected by connectors 434 extending in the Y-axis direction. Accordingly, the two Y-axis movable bodies 432 on each Y-axis rail 431 can slide together in the Y-axis direction while maintaining a constant spacing therebetween.

Further, the Y-axis movement mechanism 43 includes a driving source 433 provided at the Z-axis movable table 413 and a drive transmission part (not shown) that transmits the driving force of the driving source 433. The driving source 433 can be a motor, a cylinder mechanism, or the like, and is connected to one of the pair of X-axis rails 441. The Y-axis movement mechanism 43 operates the driving source 433 under the command of the controller 90, and transmits the driving force of the driving source 433 to the one X-axis rail 441, thereby moving one X-axis rail 441 back and forth in the Y-axis direction. Accordingly, the Y-axis movable bodies 432 that support one X-axis rail 441 move along each Y-axis rail 431, and the Y-axis movable bodies 432 that support the other X-axis rail 441 also move in the Y-axis direction via the connectors 434. As a result, the Y-axis movement mechanism 43 can slide the pair of X-axis rails 441 in the Y-axis direction while maintaining a constant spacing therebetween.

In the X-axis movement mechanism 44, the pair of X-axis rails 441 are movably held at the Y-axis movable bodies 432. In other words, each Y-axis movable body 432 has sliding portions 432a and 432b arranged in the up-down direction (vertical direction) to be movable with respect to the Y-axis rail 431 and X-axis rail 441 that are mounted in the vertical direction. The sliding portions 432a and 432b have therein a plurality of rolling bodies (not shown), and can move along the rails by the rotation of the rolling bodies.

Further, in the X-axis movement mechanism 44, a square ring-shaped X-axis movable table 442 (see FIG. 4) disposed to straddle the pair of X-axis rails 441. The X-axis movement mechanism 44 includes a driving source 443 provided on the Z-axis movable table 413, and a drive transmission part (not shown) that transmits the driving force of the driving source 443. The driving source 443 may be a motor, a cylinder mechanism, or the like, and is connected to the X-axis movable table 442. The X-axis movement mechanism 44 operates the driving source 443 under the command of the controller 90 to transmit the driving force of the driving source 443 to the X-axis movable table 442, thereby moving the X-axis movable table 442 together with the pair of X-axis rails 441 in the X-axis direction.

The horizontal movement mechanism 42 described above has a space 42s surrounded by the pair of Y-axis rails 431 and the pair of X-axis rails 441. The space 42s communicates with the space 41s of the Z-axis movable table 413, and is set to be larger than the irradiation device 50.

The θ-axis rotation mechanism 45 is provided on the X-axis movable table 442 of the X-axis movement mechanism 44, and rotates the placing table 31 around the θ-axis (vertical axis). For example, the θ-axis rotation mechanism 45 has a fixed part 451 fixed to the X-axis movable table 442, and a θ-movable portion 452 rotatably mounted on the fixed part 451. Further, the θ-axis rotation mechanism 45 has a driving source and a drive transmission part (both not shown), and operates the driving source under the command of the controller 90 to rotate the θ-movable portion 452 with respect to the fixed part 451. Each of the fixed part 451 and the θ-movable portion 452 is formed in a cylindrical shape to allow the upward movement of the irradiation device 50 to be described below, and has therein a space 45s (see also FIG. 7B).

The placing table 31 of the stage 30 is fixed to the upper surface of the θ movable portion 452 of the θ-axis rotation mechanism 45. The placing table 31 is made of a transparent material such as glass (quartz) to transmit the inspection light from the irradiation device 50 located below the stage 30 in the vertical direction. The thickness of the placing table 31 is set in consideration of the balance between the strength required to support the wafer W and the optical path length required to reduce the loss of the inspection light. For example, the thickness of the placing table 31 is preferably set within a range of about 3 mm to 30 mm. Accordingly, the wafer W can be stably supported on the placing table 31, and the loss caused by the transmission of the inspection light from the irradiation device 50 can be reduced.

As shown in FIG. 7A, the placing table 31 is formed in a square shape in plan view, and has a placing surface 31s for placing the wafer W on the upper surface thereof. A circular suction groove 32 is formed in the placing surface 31s to attract the wafer W during the inspection. The suction groove 32 is connected to a suction passage (not shown) located inside the placing table 31. The suction passage is connected to a suction mechanism 14 located outside the inspection part 10 through a suction line (see FIG. 1). The stage 30 applies a suction pressure to the suction groove 32 by the suction action of the suction mechanism 14, thereby attracting and holding the wafer W on the placing surface 31s.

The suction groove 32 is formed to attract the vicinity of the outer edge of the wafer W. For example, when the diameter of the wafer W to be inspected is 300 mm, the diameter of the suction groove 32 is set to approximately 280 mm to 295 mm. Accordingly, the side of the placing surface 31s that faces the installation locations of the imaging devices 100 on the wafer W extends flat without irregularities, thereby suppressing problems such as irregular reflection of the inspection light and enabling the inspection light to pass through the wafer W.

As shown in FIG. 7C, the placing table 31 includes a heater layer 33 for heating the placing table 31 and a sensor layer 34 for detecting the temperature of the placing surface 31s. For example, the placing table 31 is formed by laminating a glass substrate layer 35, the heater layer 33, a glass substrate layer 35, the sensor layer 34, and another glass substrate layer 35 in that order from the bottom to the top in the vertical direction. The heater layer 33 may employ a well-known transparent pattern, and is connected to the controller 90 via a driver part (not shown). The sensor layer 34 may employ an RTD pattern of a sensor, and is configured to transmit temperature detection information to the controller 90. The placing table 31 configured as described above can transmit the inspection light while reducing the loss of the inspection light, and the temperature of the heater layer 33 (i.e., the wafer W placed on the placing surface 31s) can be controlled based on the detection information from the sensor layer 34.

The structure of the placing table 31 is not limited thereto. For example, as shown in FIG. 7D, the heater layer 33 and the sensor layer 34 may be directly laminated with each other, and the glass substrate layers 35 may be laminated thereon and thereunder, respectively.

Referring back to FIG. 4, the polishing mechanism 60 of the stage 30 is installed adjacent to the θ-axis rotation mechanism 45 on the X-axis movable table 442. A polishing body 61 is located at the upper part of the polishing mechanism 60 to polish the probes 22 protruding downward from the probe card 21. The polishing mechanism 60 has a polishing-side Z-axis movement mechanism 62 that displaces the polishing body 61 in the Z-axis direction.

In the inspection part 10, the irradiation device 50 is located on the side of the stage 30 configured described above, which is the same side where the wafer W is placed, and the inspection light from the stage 30 is irradiated toward the on-chip lenses 111 of the imaging device 100. The irradiation device 50 includes a light source module 51 that is a light source of inspection light, and a lens module 52 that is located in the irradiation direction (on the optical axis) of the inspection light from the light source module 51. The irradiation device 50 further includes an irradiation device operating part 53 for moving the light source module 51 and the lens module 52.

The light source module 51 includes a housing 511 having a light blocking function, and a plurality of LEDs (not shown) installed inside the housing 511. The light source module 51 is communicatively connected to the controller 90. The housing 511 includes a protrusion 512 protruding in a vertically upward direction, and the protrusion 512 has an opening 512o on the upper surface thereof. The LEDs are arranged in a matrix pattern along the horizontal direction, for example, and emit inspection light of the same wavelength and the same light intensity in a vertically upward direction. Hence, the light source module 51 can stably irradiate the inspection light from the opening 512o in a vertically upward direction.

In the case of inspecting a plurality of colors in the imaging device 100, the light source module 51 may be configured to irradiate inspection light of a single color (e.g., white) or a plurality of colors (e.g., red, green, and blue).

The lens module 52 is a module that reproduces a lens portion of an imaging device (not shown), such as a camera or the like, on which the imaging device 100 is mounted. The lens module 51 is also referred to as "Pupil Lens Module" (Registered Trademark). In the inspection apparatus 1, by using the lens module 52 for inspection, it is possible to reproduce the environment in which the imaging device 100 is actually used, and also possible to inspect whether or not specifications determined in that environment can be satisfied. For example, most of cameras attached to smartphones have different numbers and shapes of lenses depending on models, so that the lens module 52 is designed to match the lens specifications of each camera and replaced depending on the inspection content.

The lens module 52 includes a plurality of lenses 521 that can transmit inspection light, and a support plate 522 that supports the lenses 521. For example, each lens 521 is supported at the support plate 522 with its convex surface facing vertically upward. Further, the lenses 521 are arranged in a matrix pattern on the support plate 522, and the uniformity of the light intensity of the inspection light that has transmitted through the lenses 521 can be maintained.

The support plate 522 is formed in a circular plate shape, for example. By fixing the support plate 522 to a support frame 536 of the irradiation device operating part 53, the lenses 521 and the support plate 522 are located at a position facing the opening 512o of the light source module 51 (between the light source module 51 and the placing table 31). The lenses 521 and the support plate 522 are formed to be smaller than the wafer W to be inspected in plan view. In other words, the diameter and area of the support plate 522 are formed to be smaller than the diameter and area of the placing surface 31s or the wafer W. Accordingly, the lens module 52 can guide the inspection light irradiated from the light source module 51 within a narrow area of the wafer W using the lenses 521, and maintain the average light intensity within the corresponding surface.

The irradiation device operating part 53 has a function of raising and lowering the irradiation device 50 (the light source module 51 and the lens module 52). Further, the irradiation device operating part 53 may include an irradiation device horizontal movement mechanism 54 for adjusting the horizontal position of the irradiation device 50. For example, the irradiation device operating part 53 has a base 531 that is provided at the irradiation device horizontal movement mechanism 54 and extends horizontally. The irradiation device operating part 53 has a light source module lifting mechanism 532 and a lens module lifting mechanism 535 with respect to the base 531.

The light source module lifting mechanism 532 supports the light source module 51, and raises and lowers the light source module 51 under the command of the controller 90. For example, the light source module lifting mechanism 532 includes a driving source 533, such as a motor or a cylinder mechanism, and a drive transmission part 534 that transmits the driving force of the driving source 533.

The lens module lifting mechanism 535 supports the lens module 52 via the support frame 536, and raises and lowers the lens module 52 under the command of the controller 90. For example, the lens module lifting mechanism 535 includes a driving source 537, such as a motor, a cylinder mechanism, or the like, and a drive transmission part 538 that transmits the driving force of the driving source 537.

The irradiation device horizontal movement mechanism 54 is used to finely adjust the horizontal position of the irradiation device 50 in response to the positions of the probes 22 of the probe card 21 and the position of the stage 30, for example. In FIG. 4, the irradiation device horizontal movement mechanism 54 is configured to move the base 531 along the Y-axis direction. In this case, the irradiation device horizontal movement mechanism 54 includes a pair of rails 541, a plurality of movable bodies 542 that slide on the rails 541 to support the base 531, and a driving source 543 and a drive transmission part 544 for driving in the Y-axis direction, for example. The irradiation device horizontal movement mechanism 54 may be configured to be movable in both the X-axis direction and the Y-axis direction. For example, the same configuration as that of the horizontal movement mechanism 42 of the stage 30 may be employed.

In the inspection apparatus 1 configured as described above, the position of the placing table 31 can be displaced with respect to the irradiation device 50 by moving the stage 30. Further, in the inspection apparatus 1, the irradiation device 50 can approach as closely as possible the back surface (bottom surface) of the placing table 31 of the stage 30. In other words, the placing table operating part 40 of the stage 30 extends in the vertical direction, thereby forming an irradiation device space 46 where the irradiation device 50 can be moved and positioned. The irradiation device space 46 is formed by connecting a space 41s formed in the Z-axis movement mechanism 41, a space 42s formed in the horizontal movement mechanism 42, and a space 45s formed in the θ-axis rotation mechanism 45.

The back surface of the placing table 31 faces the vertically upper side of the irradiation device space 46. The vertically lower side of the irradiation device space 46 is connected to the space located under the intermediate frame 11c in the vertical direction via an inner space (not shown) of the intermediate frame 11c. Therefore, when the irradiation device 50 is raised by the irradiation device operating part 53, the irradiation device 50 enters the irradiation device space 46 without contact with other components. In particular, the lens module 52 of the irradiation device 50 can be positioned near the back surface of the placing table 31 via the irradiation device space 46. Therefore, in the inspection apparatus 1, the distance between the lens module 52 and the imaging device 100 can be minimized, and the loss of the inspection light can be effectively reduced.

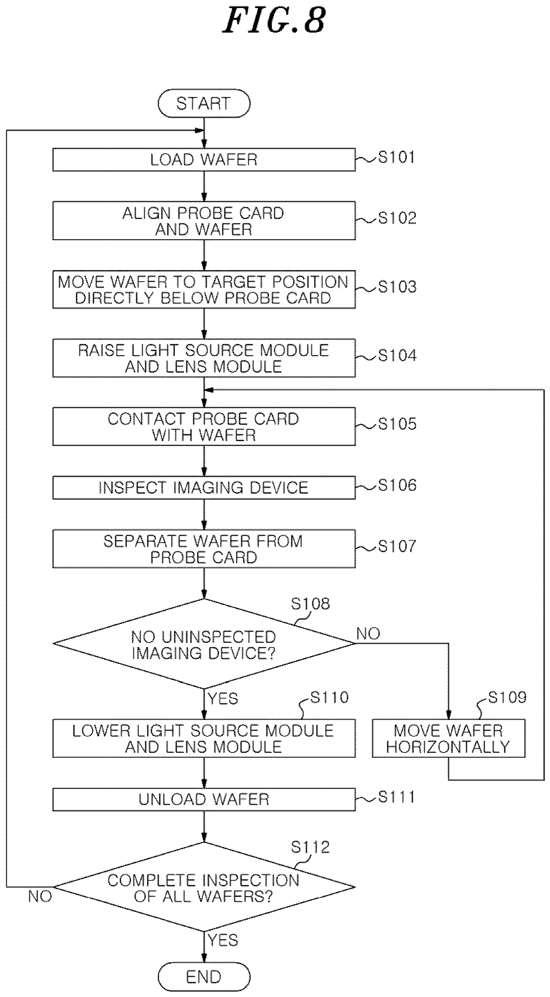

The inspection apparatus 1 according to the present embodiment is basically configured as described above. The following operation (inspection method) of the inspection apparatus 1 will be described with reference to FIG. 8. FIG. 8 is a flowchart showing the inspection method of the inspection apparatus 1.

In the inspection apparatus 1, in the case of inspecting the wafer W having the imaging device 100, first, the wafer W is placed on the placing surface 31s of the placing table 31 by the loader 13 and, then, the process flow of steps S101 to S112 shown in FIG. 8 is sequentially executed based on the command of the controller 90.

The controller 90 first controls the wafer W to be loaded from the loader 13 into the inspection part 10 and placed and held on the placing surface 31s of the placing table 31 (step S101). Next, the controller 90 operates the θ-axis rotation mechanism 45 to rotate the placing table 31 around the θ axis, thereby performing alignment between the probe card 21 and the wafer W (step S102).

Then, the controller 90 moves the placing table 31 in a horizontal direction using the horizontal movement mechanism 42 and raises the placing table 31 in a vertically upward direction using the Z-axis movement mechanism 41, thereby locating the wafer W at a target position directly below the probe card 21 (step S103). The target position is set such that the imaging device 100 is slightly spaced apart from the probes 22 of the probe card 21. During the movement of the placing table 31, the controller 90 stops the movement of the irradiation device 50, and the stage 30 changes its three-dimensional position with respect to the irradiation device 50.

During the horizontal movement by the horizontal movement mechanism 42, the irradiation device space 46 of the placing table operating part 40 also moves in a horizontal direction. However, the horizontal movement distance of the placing table 31 is short within the range where the wafer W faces and is in contact with the probes 22. Accordingly, even if the space 42s of the horizontal movement mechanism 42 deviates in the horizontal direction, it is possible to maintain a state in which the space 42s extends in the vertical direction with respect to the irradiation device space 46. In other words, even if the placing table 31 moves horizontally within the inspection range (facing range) of the wafer W, the deformation of the irradiation device space 46 does not hinder the upward movement of the irradiation device 50. Hence, even if the irradiation device 50 is raised in the subsequent step S104, the irradiation device 50 (the lens module 52) can be reliably close to the placing table 31.

Next, the controller 90 controls the irradiation device operating part 53 to raise the light source module 51 and the lens module 52 of the irradiation device 50 vertically upward to bring them close to the back surface of the placing table 31 (step S104). In this case, the controller 90 maintains the state in which the movement of the stage 30 is stopped, and the irradiation device 50 changes its vertical position with respect to the stage 30. The controller 90 may raise the irradiation device 50 when the stage 30 is raised (during step S103), and continue the upward movement of the irradiation device 50 even after the upward movement of the stage 30 is stopped due to positioning, thereby bringing the irradiation device 50 close to the back surface of the placing table 31. Accordingly, the irradiation device 50 can be raised efficiently, which makes it possible to shorten the inspection time.

The lens module 52 of the irradiation device 50 is positioned sufficiently close to the back surface of the placing table 31. For example, the gap between the back surface of the placing table 31 and the lens module 52 may be set to be smaller than the thickness of the placing table 31. As a result, the inspection light outputted from the lens module 52 can be easily guided to the imaging device 100 through the placing table 31.

Further, in the case of raising the irradiation device 50, the lens module 52 may be raised first and, then, the light source module 51 may be raised. Alternatively, the light source module 51 and the lens module 52 may be raised simultaneously. However, it is preferable to maintain a constant distance between the light source module 51 and the lens module 52 during the inspection of the imaging device 100. Therefore, when the light source module 51 and the lens module 52 are raised separately, the irradiation device operating part 53 controls the respective elevation amounts so as to maintain a constant distance therebetween.

Then, the controller 90 slightly raises the placing table 31 and the wafer W using the Z-axis movement mechanism 41 to bring the probe card 21 into contact with the wafer W (step S105). Thus, the probes 22 of the probe card 21 are in contact with the pads 115 of each imaging device 100 on the wafer W. Further, the inspection apparatus 1 may perform an operation (overdrive operation) for slightly raising the placing table 31 even after the probes 22 are in contact with the imaging device 100. Accordingly, the probes 22 can be more reliably in contact with each imaging device 100 within the inspection range.

After the probe card 21 and the wafer W are brought into contact with each other, the controller 90 performs the inspection of the imaging device 100 (step S106). In the inspection, the controller 90 controls the light source module 51 of the irradiation device 50 to irradiate the inspection light. The inspection light passes through the lenses 521 of the lens module 52, and then transmits through the placing table 31 to be incident on the on-chip lenses 111 of the imaging device 100. In response to the incidence of the inspection light, the imaging device 100 outputs an appropriate signal to the probes 22. The tester 20 can determine whether the imaging device 100 is defective or non-defective based on the signal obtained through the probes 22.

Then, the controller 90 lowers the wafer W using the Z-axis movement mechanism 41 to return the wafer W to the target position of step S3, thereby separating the wafer W from the probe card 21 (step S107).

Then, the controller 90 determines whether there is an uninspected imaging device 100 (step S108). If an uninspected imaging device 100 exists (step S108: NO), the inspection apparatus 1 moves (indexes) the wafer W horizontally using the horizontal movement mechanism 42 to inspect the uninspected imaging device 100 on the wafer W (step S109). Thus, the uninspected imaging device 100 is made to face the probes 22 of the probe card 21. Hence, the controller 90 can inspect all the imaging devices 100 on the wafer W by repeating steps S105 to S108 described above.

On the other hand, if there is no uninspected imaging device 100 (step S108: YES), it is considered that the inspection of the imaging devices 100 on the wafer W is completed. Therefore, the controller 90 lowers the light source module 51 and the lens module 52 of the irradiation device 50 to separate them from the stage 30 (step S110).

Further, the controller 90 lowers the placing table 31 using the Z-axis movement mechanism 41 and also moves the placing table 31 horizontally using the horizontal movement mechanism 42 so that the placing table 31 becomes close to the loader 13, and then unloads the wafer W using the transfer mechanism of the loader 13 (step S111).

Then, the controller 90 determines whether or not the inspection of the wafers W accommodated in the loader 13 has been completed (step S112). If inspection has not been completed (step S112: NO), the controller 90 returns to step S101 and repeats the same process flow. On the other hand, if the inspection has been completed (step S112: YES), the process flow of the inspection method is ended.

The inspection apparatus 1 and the inspection method are not limited to the above embodiments, and may be modified variously.

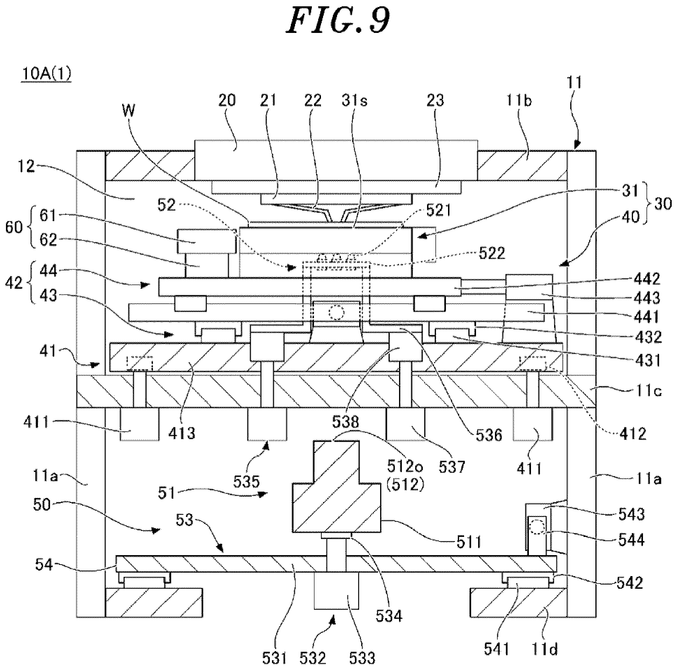

FIG. 9 is a partial side cross-sectional view showing an overall configuration of an inspection part 10A according to another embodiment. As shown in FIG. 9, the inspection part 10A may have a configuration in which the lens module lifting mechanism 535 of the irradiation device 50 and the lens module 52 are attached to the intermediate frame 11c. Accordingly, the elevation distance of the lens module 52 can be shortened, which makes is possible to perform the inspection more efficiently.

The technical ideas and effects of the present disclosure described in the above embodiment are described below.

A first aspect of the present disclosure provides the inspection apparatus 1 for an inspection object (wafer W) having the imaging device 100 to which light is incident from a surface opposite to the wiring layer 114. The inspection apparatus 1 includes the light-transmitting placing table 31 having the placing surface 31s on which the inspection object is placed so that the surface opposite to the wiring layer 114 of the imaging device 100 faces the placing surface 31s, the placing table operating part 40 configured to move the placing table 31 vertically and horizontally, and the irradiation device 50 configured to irradiate inspection light to the imaging device 100 through the placing surface 31s. The placing table operating part 40 changes a relative position of the irradiation device 50 with respect to the inspection object placed on the placing surface 31s by moving the placing table 31.

As described above, the inspection apparatus 1 can change the relative position of the inspection object (the wafer W) placed on the placing table 31 and the irradiation device 50, so that the inspection light from the irradiation device 50 can be effectively incident on the imaging device 100 of the inspection object. Hence, the inspection apparatus 1 can accurately inspect the imaging device 100.

Further, the placing table operating part 40 has the irradiation device space 46 that extends in the vertical direction on an inner side thereof and is configured to accommodate the irradiation device 50. Hence, in the inspection apparatus 1, the irradiation device 50 can be located close to the back surface of the placing table 31, and sufficient inspection light can be irradiated to the imaging device 100 placed on the placing table 31.

Further, the placing table operating part 40 includes the horizontal movement mechanism 42 having the pair of first rails (Y-axis rails 431) extending in a first direction and a pair of second rails (X-axis rails 441) overlapping the pair of first rails and extending in a second direction perpendicular to the first direction. The horizontal movement mechanism 42 has the space 42s forming the irradiation device space 46 inside the pair of first rails and the pair of second rails. Accordingly, in the inspection apparatus 1, even in the configuration including the horizontal movement mechanism 42, the irradiation device 50 can be positioned near the placing table 31.

Further, the placing table operating part 40 includes the θ-axis rotation mechanism 45 that rotates the placing table 31 around the axis. The θ-axis rotation mechanism 45 includes the cylindrical fixed portion 451 and the cylindrical θ-movable portion 452 that can rotate with respect to the fixed portion 451. The θ-axis rotation mechanism 45 has the space 45s forming the irradiation device space 46 inside the fixed portion 451 and the movable portion 452. Hence, in the inspection apparatus 1, even in the configuration in which the placing table 31 rotates around the axis, the irradiation device 50 can be positioned near the placing table 31.

Further, the placing table operating part 40 includes the Z-axis movement mechanism 41 that raises and lowers the placing table 31. The Z-axis movement mechanism 41 includes the driving source 411 and the Z-axis movable table 413 that is raised and lowered by the driving source 411. The Z-axis movable table 413 has therein the space 41s defining the irradiation device space 46. Accordingly, in the inspection apparatus 1, even in the configuration in which the placing table 31 is raised and lowered vertically, the irradiation device 50 can be positioned near the placing table 31.

Further, the irradiation device 50 includes the light source module 51 that irradiates inspection light, and the lens module 52 that is located between the light source module 51 and the placing table 31 and has the plurality of lenses 521. By providing the light source module 51 and the lens module 52, the inspection apparatus 1 can irradiate appropriate inspection light to the imaging device 100.

Further, the light source module 51 and the lens module 52 can independently movable from each other. Therefore, in the inspection apparatus 1, the light source module 51 and the lens module 52 can be located at appropriate positions during the inspection.

Further, the inspection apparatus 1 includes the controller 90 that controls the placing table operating part 40 and the irradiation device 50. The controller 90 is configured to bring the irradiation device 50 close to the placing table 31 while or after positioning of the placing table 31 by movement of the placing table operating part 40. Accordingly, in the inspection apparatus 1, the irradiation device 50 can be accurately located at a position corresponding to the placing table 31 positioned by the movement of the placing table operating part 40.

Further, when the irradiation device 50 is brought close to the placing table 31, the gap between the lens module 52 and the placing table 31 is less than the thickness of the placing table 31. Accordingly, in the inspection apparatus 1, the irradiation device 50 can become sufficiently close to the placing table 31, which makes it possible to eliminate the loss of inspection light.

Further, the placing table 31 has a laminated structure having the heater layer 33 that can transmit the inspection light and heat the placing table 31, and the sensor layer 34 that can transmit the inspection light and detect the temperature of the placing table 31. Hence, in the inspection apparatus 1, the inspection can be performed while adjusting the temperature of the placing table 31, and the loss of the inspection light can be suppressed.

A second aspect of the present disclosure is an inspection method for inspecting an inspection object (wafer W) having the imaging device 100 on which light is incident from a surface opposite to the wiring layer 114 using the inspection apparatus 1. The inspection apparatus 1 includes the light-transmitting placing table 31 having the placing surface 31s on which the inspection object is placed so that the surface opposite to the wiring layer 114 of the imaging device 100 faces the placing surface 31s, the placing table operating part 40 capable of moving the placing table 31 vertically and horizontally, and the irradiation device 50 that irradiates inspection light to the imaging device 100 through the placing surface 31s. The inspection method includes the steps of: changing a relative position of the irradiation device 50 with respect to the inspection object placed on the placing surface 31s by moving the placing table 31 using the placing table operating part 40; and after the step of changing the relative position of the irradiation device 50 with respect to the inspection object, irradiating the inspection light to the imaging device 100 using the irradiation device 50 to perform inspection of the imaging device 100. In this case as well, the imaging device can be inspected accurately by the inspection method.

The inspection apparatus 1 and the inspection method according to the embodiments of the present disclosure are considered to be illustrative in all respects and not restrictive. The above-described embodiments can be changed and modified in various forms without departing from the scope of the appended claims and the gist thereof. The above-described embodiments may include other configurations without contradicting each other and may be combined without contradicting each other.

This application claims priority to Japanese Patent Application No. 2023-90424 filed on May 31, 2023, the entire contents of which are incorporated herein by reference.

### Description of Reference Numerals

1: inspection apparatus
31: placing table
31s: placing surface
40: placing table operating part
50: irradiation device
100: imaging device
114: wiring layer
W: wafer

## Claims

1. An inspection apparatus for an inspection object having an imaging device to which light is incident from a surface opposite to a wiring layer, comprising:
a light-transmitting placing table having a placing surface on which the inspection object is placed so that the surface opposite the wiring layer of the imaging device faces the placing surface;
a placing table operating part configured to move the placing table vertically and horizontally; and
an irradiation device configured to irradiate inspection light to the imaging device through the placing surface,
wherein the placing table operating part changes a relative position of the irradiation device with respect to the inspection object placed on the placing surface by moving the placing table.

2. The inspection apparatus of claim 1, wherein the placing table operating part has an irradiation device space that extends in a vertical direction on an inner side thereof and is configured to accommodate the irradiation device.

3. The inspection apparatus of claim 2, wherein the placing table operating part includes a horizontal movement mechanism having a pair of first rails extending in a first direction and a pair of second rails overlapping the pair of first rails and extending in a second direction perpendicular to the first direction, and
the horizontal movement mechanism has the irradiation device space inside the pair of first rails and inside the pair of second rails.

4. The inspection apparatus of claim 2, wherein the placing table operating part includes a θ-axis rotation mechanism configured to rotate the placing table around an axis,
the θ-axis rotation mechanism includes a cylindrical fixed portion and a cylindrical θ-axis movable portion that is rotatable with respect to the fixed portion, and
the irradiation device space is provided inside the fixed portion and the movable portion.

5. The inspection apparatus of claim 2, wherein the stage operating part includes a Z-axis movement mechanism configured to raise and lower the placing table,
the Z-axis movement mechanism includes a driving source and a Z-axis movable stage that is raised and lowered by the driving of the driving source, and
the Z-axis movable stage has therein a space defining the irradiation device space.

6. The inspection apparatus of any one of claims 1 to 5, wherein the irradiation device includes a light source module configured to irradiate the inspection light, and a lens module disposed between the light source module and the placing table and having a plurality of lenses.

7. The inspection apparatus of claim 6, wherein the light source module and the lens module are independently movable from each other.

8. The inspection apparatus of claim 7, further comprising:
a controller configured to control the placing table operating part and the irradiation device,
wherein the controller is configured to bring the irradiation device closer to the placing table while or after positioning of the placing table by movement of the placing table operating part.

9. The inspection apparatus of claim 8, wherein a gap between the lens module and the placing table is less than a thickness of the placing table when the irradiation device is brought close to the placing table.

10. The inspection apparatus of any one of claims 1 to 5, wherein the placing table has a laminated structure having a heater layer that transmits the inspection light and heats the placing table, and a sensor layer that transmits the inspection light and detects a temperature of the placing table.

11. An inspection method for inspecting an inspection object having an imaging device to which light is incident from a surface opposite to a wiring layer using an inspection apparatus, wherein the inspection apparatus includes:
a light-transmitting placing table having a placing surface on which the inspection object is placed so that the surface opposite to the wiring layer of the imaging device faces the placing surface;
a placing table operating part configured to move the placing table vertically and horizontally; and
an irradiation device configured to irradiate inspection light to the imaging device through the placing surface;
the inspection method comprising:
changing a relative position of the irradiation device with respect to the inspection object placed on the placing surface by moving the placing table using the placing table operating part; and
after changing the relative position of the irradiation device with respect to the inspection object, irradiating the inspection light to the imaging device using the irradiation device to perform inspection of the imaging device.
